# FASCICULE DE BREVET EUROPEEN

(11) **EP 2 990 814 B1**
(45) Date de publication et mention de la délivrance du brevet: **14.07.2021**
(21) Numéro de dépôt: 15181764.0
(22) Date de dépôt: 20.08.2015
(51) Int. Cl.: G01R 29/10, H01Q 19/13, H01Q 19/19

(54) **PROCÉDÉ ET DISPOSITIF DE MESURE DE PRODUITS D'INTERMODULATION PAR RÉFLEXION D'ONDES ÉLECTROMAGNÉTIQUES SUR UN OBJET**
VERFAHREN UND VORRICHTUNG ZUM MESSEN VON PRODUKTEN ZUR INTERMODULATION DURCH REFLEXION VON ELEKTROMAGNETISCHEN WELLEN AUF EIN OBJEKT
METHOD AND DEVICE FOR MEASURING INTERMODULATION PRODUCTS BY REFLECTION OF ELECTROMAGNETIC WAVES ON AN OBJECT

(30) Priorité: 26.08.2014 FR 1457996
(43) Date de publication de la demande: 02.03.2016
(73) Titulaire: Centre National d'Etudes Spatiales (C.N.E.S.), 75001 Paris (FR)
(72) Inventeur: SOMBRIN, Jacques, 31400 TOULOUSE (FR); ALBERT, Isabelle, 31750 ESCALQUENS (FR); SOUBERCAZE-PUN, Geoffroy, 31130 FLOURENS (FR); CAPET, Nicolas, 31000 TOULOUSE (FR)
(74) Mandataire: Delorme, Nicolas

(56) Documents cités:
- WO-A1-2013/185694
- US-A- 6 144 692

## Description

L'invention concerne un procédé et un dispositif de mesure de puissance de produits d'intermodulation, en particulier des produits d'intermodulation produits par réflexion d'onde sur un objet non-linéaire au moins partiellement réfléchissant.

Les phénomènes d'intermodulation apparaissent pour des dispositifs électromagnétiques fonctionnant avec plusieurs fréquences simultanément lorsque des objets se comportant de façon non linéaire se trouvent à proximité. L'intermodulation est le résultat de distorsions générées par ces objets non-linéaires à partir d'une onde électromagnétique incidente. L'intermodulation se manifeste notamment par l'apparition de nouvelles composantes de fréquences dans l'onde électromagnétique. Les fréquences de ces composantes d'intermodulation sont obtenues par addition ou soustraction de multiples des fréquences présentes dans l'onde électromagnétique incidente sur ledit objet non-linéaire. Le résultat de l'addition des modules des facteurs multiplicateurs des fréquences de l'onde électromagnétique incidente utilisés pour obtenir la fréquence d'une composante d'intermodulation est désigné par "ordre d'intermodulation".

On cherche généralement à évaluer la puissance de distorsions d'intermodulation passive car elles ne peuvent pas toutes être éliminées par filtrage - au contraire de distorsions d'intermodulation active hors bande (provoquées par des composants actifs). Or la puissance des produits d'intermodulation passifs devient significative dans les dispositifs électroniques fonctionnant à des niveaux de puissance élevés.

Il est donc particulièrement important de déterminer la puissance de produits d'intermodulation produits par des objets non-linéaires situés à proximité de dispositifs électromagnétiques tels que des antennes d'émission/réception par exemple.

En effet, dans les dispositifs électroniques de télécommunications à bande large, des produits d'intermodulation passive issus des signaux d'émission ont des fréquences dans la bande de réception. Cela est d'autant plus le cas que les bandes de radiofréquences de télécommunications sont de plus en plus densément peuplées. Or les signaux de réception étant toujours de puissance inférieure aux signaux d'émission, les produits d'intermodulation passive issus des signaux d'émission peuvent bruiter la réception de signaux d'information de façon significative.

Tel est par exemple le cas dans les dispositifs d'émission/réception de signaux de télécommunications de longue portée qui utilisent un grand nombre de fréquences porteuses en émission et en réception, et ce en bande large. Ce phénomène est particulièrement gênant dans les dispositifs de télécommunications à bord de satellites, d'avions ou, au sol, dans les relais de télécommunications pour téléphones mobiles. Les phénomènes d'intermodulation y sont suffisamment importants pour avoir conduit certains constructeurs de satellites à doubler leur dispositif d'émission/réception, ce qui représente un coût supplémentaire de fabrication et de lancement très élevé.

Il est donc essentiel de pouvoir évaluer et prédire les niveaux de puissance de ces produits d'intermodulation afin de mieux les prendre en compte lors de la conception du dispositif. Il est en particulier essentiel de pouvoir mesurer les puissances produites par un objet en particulier, notamment par un échantillon de matériau particulier.

Dans de nombreux procédés de mesure de produits d'intermodulation produits par un objet, une onde électromagnétique est émise par deux antennes sur un réflecteur et l'onde réfléchie par ledit objet est mesurée par un récepteur. Un tel procédé est ainsi décrit dans US 6,144,692. Le récepteur comprend un dispositif de démodulation comprenant un démultiplexeur permettant de réaliser une mesure de puissance de chaque composante de l'onde électromagnétique reçue par le récepteur.

De tels dispositifs présentent de nombreux inconvénients. Ainsi, un tel dispositif ne permet pas de réaliser des mesures sur certaines bandes de fréquences importantes. Ainsi, il n'est pas possible de réaliser des mesures à des fréquences situées entre celles de deux composantes fondamentales formant une onde incidente, ni à des fréquences situées au-delà de la bande passante totale du démultiplexeur. Il est aussi impossible de mesurer des puissances de produits d'intermodulation dont la fréquence est en dehors de la bande de réception du démultiplexeur.

En outre, de tels démultiplexeurs introduisent eux-mêmes des produits d'intermodulation passive et leur qualité influe largement sur le coût du dispositif de mesure.

L'invention vise donc à pallier ces inconvénients.

L'invention vise à proposer un procédé de mesure de produits d'intermodulation permettant de réaliser une mesure de produits d'intermodulation fiable et précise pour toute composante de toute fréquence.

L'invention vise également à proposer un tel procédé qui soit économique et simple.

L'invention vise en outre à proposer un dispositif de mesure de produits d'intermodulation permettant de réaliser une mesure de produits d'intermodulation produits par un objet non-linéaire.

L'invention vise aussi à proposer un dispositif générique pouvant être utilisé pour effectuer successivement des mesures sur plusieurs objets, sans modification du dispositif de mesure.

Dans tout le texte, on désigne par "puissance d'intermodulation" la puissance d'un produit d'intermodulation (d'ordre et donc de fréquence déterminée). Une telle puissance d'intermodulation peut être exprimée en Watts (W), milliWatts (mW), ou décibels relatifs à un milliwatt (dBm).

L'invention concerne donc un procédé de mesure de puissance de produits d'intermodulation produits par réflexion d'une onde électromagnétique sur un objet non-linéaire, dans lequel :
- une première source électromagnétique émet une première onde électromagnétique comprenant au moins une composante, dite première composante fondamentale, à partir d'un premier foyer,
- une deuxième source électromagnétique émet une deuxième onde électromagnétique, comprenant au moins une composante, dite deuxième composante fondamentale, à partir d'un deuxième foyer distinct du premier foyer,
- lesdites première onde électromagnétique et deuxième onde électromagnétique forment une onde électromagnétique, dite onde émise :
   ▪ se propageant desdites sources jusqu'audit objet non-linéaire au moins,
   ▪ étant au moins partiellement réfléchie sur ledit objet non-linéaire, et enrichie en composantes, dites composantes d'intermodulation, correspondant à des produits d'intermodulation produits par ledit objet non-linéaire à partir desdites première composante fondamentale et deuxième composante fondamentale de l'onde émise, de façon à former une onde électromagnétique, dite onde enrichie, comprenant la première composante fondamentale, la deuxième composante fondamentale et lesdites composantes d'intermodulation,
- ladite onde enrichie se propage au moins pour partie dudit objet non-linéaire à au moins un récepteur électromagnétique,
ledit procédé étant caractérisé en ce qu'il comprend:
- au moins une étape de déplacement choisie parmi :
   ▪ ledit objet est déplacé en rotation autour d'au moins un axe par rapport audit récepteur, au moins entre une première position de mesure et une deuxième position de mesure,
   ▪ un réflecteur adapté pour réfléchir une onde électromagnétique sans l'enrichir en composantes, est déplacé en rotation autour d'au moins un axe par rapport audit récepteur, au moins entre une première position de mesure et une deuxième position de mesure, et
   ▪ ledit récepteur est déplacé en translation selon au moins une direction distincte d'une direction d'incidence de ladite onde enrichie sur ledit récepteur, au moins entre une première position de mesure et une deuxième position de mesure,
- et au moins une étape dans laquelle ledit récepteur électromagnétique produit au moins un signal, dit signal de mesure, représentatif au moins de la puissance d'au moins une composante de l'onde enrichie, pour ladite première position et au moins un signal de mesure pour ladite deuxième position.

En particulier, l'invention concerne un procédé de mesure de puissance de produits d'intermodulation produits par réflexion d'une onde électromagnétique sur un objet non-linéaire, dans lequel on utilise un dispositif de mesure comprenant :
- une première source électromagnétique émettant à partir d'un premier foyer une première onde électromagnétique comprenant au moins une composante, dite première composante fondamentale,
- une deuxième source électromagnétique émettant à partir d'un deuxième foyer distinct du premier foyer, une deuxième onde électromagnétique comprenant au moins une composante, dite deuxième composante fondamentale,
- un objet non-linéaire disposé de façon à pouvoir être irradié par lesdites première composante fondamentale et deuxième composante fondamentale, et à former une onde électromagnétique, dite onde enrichie, comprenant ladite première composante fondamentale, ladite deuxième composante fondamentale et des composantes, dites composantes d'intermodulation,
- un dispositif de réception électromagnétique adapté pour produire au moins un signal, dit signal de mesure, représentatif au moins de la puissance d'au moins une composante d'une onde électromagnétique reçue par ce dispositif de réception,
- le dispositif de mesure étant agencé dans au moins une configuration spatiale, dite configuration de mesure, dans laquelle ladite onde enrichie se propage au moins pour partie jusqu'au dispositif de réception,
caractérisé en ce que, l'onde enrichie ayant une composition variable dans l'espace, il comprend :
- une première étape de mesure dans laquelle le dispositif de mesure est agencé dans une première configuration spatiale, dite première configuration de mesure adaptée pour que ledit dispositif de réception produise au moins un premier signal de mesure pour une première partie ayant une première composition de l'onde enrichie,
- et au moins une deuxième étape de mesure dans laquelle le dispositif de mesure est agencé dans une deuxième configuration spatiale, dite deuxième configuration de mesure distincte, de ladite première configuration de mesure, adaptée pour que ledit dispositif de réception produise au moins un deuxième signal de mesure pour une deuxième partie ayant une deuxième composition de l'onde enrichie distincte de la première composition de l'onde enrichie.

L'onde émise comprend au moins une composante de chacune des deux sources électromagnétiques. L'onde enrichie comprend aussi au moins une composante de chacune des deux sources électromagnétiques.

Les inventeurs ont constaté que les composantes d'intermodulation passive d'une onde enrichie produites par un objet non-linéaire soumis à une onde électromagnétique (« onde émise ») comprenant une pluralité de composantes électromagnétiques, dites composantes fondamentales, issues de sources de foyers distincts ont une direction de propagation dans l'espace distincte de celle des composantes fondamentales réfléchies par ledit objet. Cela est vrai que la première composante fondamentale et la deuxième composante fondamentale issues de sources de foyers distincts soient de même fréquence ou non.

Ladite onde enrichie n'est donc pas homogène dans l'espace ; sa composition varie dans l'espace. Des résultats de mesures réalisées sur une ou plusieurs composantes de l'onde enrichie varient donc en fonction de la position à laquelle chaque mesure est effectuée par rapport à l'onde enrichie.

Dans un procédé selon l'invention, au moins une composante de puissance non-nulle de l'onde enrichie est reçue par ledit récepteur pour ladite première configuration de mesure, et au moins une composante de puissance non-nulle de l'onde enrichie est reçue par ledit récepteur pour ladite deuxième configuration de mesure, ladite puissance ou ladite composante étant distinctes dans la première configuration de mesure et dans la deuxième configuration de mesure.

Un dispositif de mesure selon l'invention comprend une pluralité d'éléments parmi lesquels au moins : les deux sources, l'objet non-linéaire, un dispositif de réception, et facultativement un ou plusieurs réflecteurs simples interposés sur le chemin de l'onde électromagnétique entre lesdites sources et ledit dispositif de réception.

Une configuration de mesure selon l'invention correspond à une configuration spatiale, c'est-à-dire une position et une orientation spatiale, de chacun des éléments du dispositif de mesure les uns par rapport aux autres. Il s'agit notamment d'une configuration spatiale fonctionnelle permettant de réaliser une mesure de puissance de composantes de l'onde enrichie formée par un objet linéaire.

Les modifications de configuration de mesure peuvent être discrètes ou continues.

Le dispositif de réception comprend au moins un récepteur, et peut en comprendre plusieurs.

Avantageusement et selon l'invention, ledit procédé est caractérisé en ce qu'il comprend en outre une étape de modification de la configuration de mesure de ladite première configuration de mesure à ladite deuxième configuration de mesure, cette étape de modification étant choisie parmi :
- une étape de déplacement dudit objet non-linéaire en rotation autour d'au moins un axe par rapport audit dispositif de réception, au moins entre une première configuration de mesure et une deuxième configuration de mesure,
- une étape de déplacement d'un réflecteur adapté pour réfléchir une onde électromagnétique sans l'enrichir en composantes, en rotation autour d'au moins un axe par rapport audit dispositif de réception, au moins entre une première configuration de mesure-et une deuxième configuration de mesure, et
- une étape de déplacement dudit dispositif de réception en translation selon au moins une direction distincte d'une direction d'incidence de ladite onde enrichie sur ledit dispositif de réception, au moins entre une première configuration de mesure et une deuxième configuration de mesure,

Conformément à l'invention :
- l'objet non-linéaire est pivoté de façon à balayer un champ dans lequel se trouve au moins un récepteur, ou
- un réflecteur disposé sur le chemin de l'onde enrichie (c'est-à-dire entre l'objet non-linéaire et ledit récepteur) est pivoté de façon à balayer un champ dans lequel se trouve au moins un récepteur, ou ledit récepteur est déplacé dans un champ d'émission de l'onde enrichie selon une direction distincte de la direction de propagation de l'onde réfléchie.

Avantageusement et selon l'invention, ledit procédé est caractérisé en ce qu'il comprend en outre une étape de modification de la configuration du système de transmission comprenant au moins une étape de déplacement choisie parmi :
- une étape de déplacement dudit objet non-linéaire en rotation autour d'au moins deux axes distincts par rapport audit dispositif de réception,
- une étape de déplacement dudit réflecteur en rotation autour d'au moins deux axes distincts par rapport audit dispositif de réception, et
- une étape de déplacement dudit récepteur en translation selon au moins deux directions distinctes entre elles et distinctes chacune de la direction d'incidence de ladite onde enrichie sur ledit dispositif de réception.

Dans un procédé conforme à l'invention, rien n'empêche de combiner deux ou plus de ces alternatives.

Le récepteur est avantageusement déplacé dans un cône d'angle au sommet inférieur à 150°, notamment avantageusement de l'ordre de 130°.

Lorsque ledit récepteur est déplacé, il est avantageusement déplacé selon une direction formant un angle compris entre 60° et 120° avec la direction d'incidence de l'onde enrichie, c'est-à-dire la direction de propagation de l'onde enrichie lorsqu'elle rencontre ledit récepteur, en particulier avantageusement selon une direction orthogonale avec la direction de propagation de l'onde réfléchie. Généralement, dans un procédé conforme à l'invention,
- la première onde électromagnétique comprend au moins une composante, dite première composante fondamentale, à une première fréquence,
- la deuxième onde électromagnétique comprend au moins une composante, dite deuxième composante fondamentale, à une deuxième fréquence distincte de la première fréquence.

Les composantes d'intermodulation sont de fréquences obtenues par addition ou soustraction de multiples des fréquences fondamentales, par exemple pour deux fondamentales de fréquences f1 et f2, des composantes d'intermodulation de fréquences f2-f1, fl+f2 ; 2f2-f1, 2f1-f2 ; 2f2-2f1, 2f2+2f1 ; ... sont susceptibles d'être créées. L'ordre d'une composante d'intermodulation est calculé comme la somme des modules des coefficients multiplicateurs appliqués aux fréquences f1 et f2 pour obtenir la fréquence de ladite composante d'intermodulation. La composante d'intermodulation de fréquence 2f2-f1 par exemple est d'ordre 3.

Or les composantes d'intermodulation les plus gênantes sont généralement les composantes d'intermodulation d'ordre impair dont les fréquences sont proches des fréquences des composantes fondamentales f1 et f2. Elles sont difficilement filtrées et peuvent être retrouvées dans une bande de réception, notamment en bande large, lorsque la largeur de la bande d'émission est supérieure à 1% de l'écart entre la fréquence d'émission et la fréquence de réception. Cependant, lorsque les composantes fondamentales ont des fréquences identiques, des composantes d'intermodulation sont aussi produites, qui ont une fréquence identique aux composantes fondamentales. L'invention s'applique aussi de façon avantageuse à de telles composantes d'intermodulation. En effet, de telles composantes sont particulièrement gênantes car elles sont nécessairement à la même fréquence que les fréquences utiles (dites fondamentales). En particulier, de telles composantes d'intermodulation à la même fréquence que les composantes fondamentales peuvent être en décalage de phase, notamment en opposition de phase avec les composantes fondamentales, de sorte qu'elles réduisent la puissance reçue des composantes fondamentales. L'invention présente l'avantage de permettre de déterminer leur puissance et leur répartition spatiale.

Le filtrage spatial des composantes est par ailleurs le seul moyen de séparer et de mesurer les diverses composantes lorsque les fréquences f1 et f2 sont égales ou proches ainsi que toutes les fréquences des composantes d'intermodulation impaires de la forme mf2-(m-1)f1 ou mf1-(m-1)f2, avec m un entier naturel positif.

L'invention permet de mesurer des puissances de composantes d'intermodulation sans filtrage électronique. L'invention permet notamment de réaliser un filtrage spatial de composantes dont la mesure de puissance n'est pas utile ou est gênante, en particulier des composantes fondamentales dont la puissance est normalement très élevée en comparaison avec les puissances des composantes d'intermodulation. L'invention permet plus particulièrement de filtrer les composantes d'ordre faible, pour réaliser des mesures de puissance sur des composantes d'intermodulation d'ordre supérieur, qui sont normalement de puissance très inférieure auxdites composantes d'intermodulation d'ordre faible.

Le signal de mesure produit par le récepteur est avantageusement représentatif au moins de la puissance d'au moins une composante de l'onde enrichie incidente sur au moins une antenne du récepteur. Le signal de mesure peut être représentatif d'autres informations telles que la fréquence de chaque composante, associée à la puissance incidente de cette composante sur le récepteur. Lorsque l'onde enrichie comporte plusieurs composantes, et que plusieurs de ces composantes sont incidentes sur le récepteur, le signal de mesure est avantageusement représentatif d'une pluralité de - mais pas nécessairement de toutes - composantes de l'onde enrichie incidente.

Avantageusement et selon l'invention, les fréquences desdites première composante fondamentale et deuxième composante fondamentale sont dans un domaine de fréquences présentant un recouvrement de fréquence non-nul avec une bande passante de l'objet non-linéaire.

De plus, avantageusement et selon l'invention, les fréquences desdites première composante fondamentale et deuxième composante fondamentale sont dans le domaine des radiofréquences.

La fréquence de chaque composante fondamentale est avantageusement inférieure à 300 GHz.

L'objet et chaque réflecteur disposés entre chaque source et le récepteur est avantageusement au moins partiellement réfléchissant dans le domaine des rayonnements radiofréquences - notamment de fréquence inférieure à 300 GHz.

Le signal de mesure est avantageusement un signal numérique.
Avantageusement et selon l'invention, ladite première configuration de mesure et ladite deuxième configuration de mesure sont choisies de sorte que le signal de mesure d'au moins une composante de l'onde enrichie incidente sur ledit récepteur est distinct dans la première configuration de mesure et dans la deuxième configuration de mesure.

Avantageusement et selon l'invention, au moins une configuration de mesure est choisie pour que la puissance d'au moins une composante d'intermodulation de l'onde enrichie puisse être mesurée de façon fiable.

Dans un procédé selon l'invention, avantageusement, au moins un signal de mesure est produit par le dispositif de réception pour au moins une configuration de mesure dans laquelle la puissance de l'onde enrichie est inférieure à la puissance de saturation dudit dispositif de réception.

La puissance de l'onde enrichie est une puissance surfacique, et elle est comparée à la puissance maximale de saturation dudit dispositif de réception multipliée par la surface du récepteur du dispositif de réception. La puissance totale de l'onde reçue par le dispositif de réception doit être inférieure à la puissance de saturation dudit dispositif de réception. Un choix approprié de configuration de mesure permet cela, notamment en plaçant le dispositif de réception dans une zone de l'espace dans laquelle les composantes fondamentales de l'onde enrichie sont de puissance moindre.
Dans au moins une étape d'un procédé selon l'invention, au moins un signal de mesure est produit par le récepteur pour au moins une configuration de mesure dans laquelle une mesure de puissance d'une composante d'intermodulation de l'onde enrichie peut être effectuée sans perturbation du récepteur (notamment sans perturbation d'un analyseur de spectre du récepteur) par d'autres composantes de l'onde enrichie.

Ainsi, réaliser un filtrage spatial de fréquence selon l'invention permet de ne pas saturer le récepteur avec des composantes fréquentielles dont la mesure n'est pas utile, et donc d'obtenir une mesure fiable de puissance d'au moins une composante d'intermodulation.

De plus, avantageusement, dans un procédé selon l'invention, au moins un signal de mesure est produit par le dispositif de réception pour une première configuration de mesure dans laquelle le rapport de la puissance des composantes fondamentales sur la puissance d'une composante d'intermodulation est inférieur à la dynamique dudit dispositif de réception.

Cela permet de mesurer la puissance de ladite composante d'intermodulation de façon suffisamment fiable.

Cette condition est dite compatible avec la dynamique du récepteur. Avantageusement si cette dynamique est supérieure d'au moins un rapport 10 entre les composantes fondamentales et les composantes d'intermodulation mesurées, alors la précision de mesure des composantes d'intermodulation mesurées est meilleure de 0.5 dB.

De plus, avantageusement, dans un procédé selon l'invention, au moins un signal de mesure est produit par le dispositif de réception pour une première configuration de mesure dans laquelle le rapport de la puissance d'une première composante d'intermodulation sur la puissance d'une deuxième composante d'intermodulation est inférieur à la dynamique dudit dispositif de réception.

Cela permet de mesurer la puissance de ladite deuxième composante d'intermodulation de façon suffisamment fiable. Plus particulièrement, afin d'obtenir des mesures plus précises, on peut choisir un rapport moindre, en particulier par exemple un rapport de la puissance d'une première composante d'intermodulation sur la puissance d'une deuxième composante d'intermodulation inférieur de 3dB à la dynamique dudit dispositif de réception.

Dans un dispositif perfectionné actuel, la dynamique est d'environ 70dB. Il suffirait donc que le rapport de la puissance d'une première composante d'intermodulation sur la puissance d'une deuxième composante d'intermodulation soit inférieur à 70dB, et plus particulièrement inférieur à 67dB. Néanmoins rien n'empêche, dans le cadre de l'invention, et si la dynamique de dispositifs de réception conformes à l'invention s'améliore, de pouvoir réaliser des mesures avec un rapport de la puissance d'une première composante d'intermodulation sur la puissance d'une deuxième composante d'intermodulation supérieur à 70dB.

Dans un procédé selon l'invention, il est en particulier possible d'effectuer au moins une mesure dans au moins une première configuration de mesure dans laquelle la puissance d'au moins une composante fondamentale ou d'au moins une composante d'intermodulation d'ordre 3 est mesurable par le récepteur, et au moins une deuxième configuration de mesure dans laquelle au moins une composante d'intermodulation d'ordre 5 est reçue par le récepteur avec une puissance compatible avec la dynamique du récepteur par rapport à la puissance de toute composante d'ordre inférieur, notamment toute composante fondamentale (ordre 1) et toute composante d'intermodulation d'ordre 3. Dans cette deuxième configuration de mesure, les composantes fondamentales ne sont pas incidentes sur le récepteur (la mesure de signal pour ces composantes est représentative d'une puissance nulle). Ainsi dans cette deuxième configuration de mesure, ce sont les produits d'intermodulation d'ordre 5 (parmi les produits d'ordre impair) qui sont les plus puissants, de sorte que leur mesure peut être effectuée de façon fiable et précise par le récepteur. En effet, les produits d'intermodulation d'ordre 5 ne sont alors pas bruités par des composantes plus puissantes telles que les composantes fondamentales ou les composantes d'intermodulation d'ordre 3. Seules subsistent, dans l'onde enrichie incidente sur le récepteur, des composantes d'ordre inférieur à l'état de traces (fondamentales et ordre 3) et des composantes d'intermodulation d'ordre supérieur (7, 9, etc.) et donc elles aussi de puissance très inférieure.

De même, une mesure de puissance d'au moins une composante d'intermodulation d'ordre 3 est avantageusement réalisée dans une configuration de mesure dans laquelle les composantes fondamentales ne sont pas incidentes sur le récepteur (c'est-à-dire que la mesure de signal pour les composantes fondamentales est représentative d'une puissance compatible avec la dynamique du récepteur par rapport à la puissance de ladite composante d'intermodulation d'ordre 3).

Ainsi, la puissance d'une pluralité de composantes d'intermodulation peut être mesurée, sans être significativement bruitée par des composantes de puissance plus importante.

Avantageusement et selon l'invention, au moins une configuration de mesure est choisie en fonction d'au moins une composante d'intermodulation dont la mesure de puissance dans ladite onde enrichie est utile.

En effet, le déplacement d'au moins un élément choisi parmi l'objet, un réflecteur ou le récepteur permet de filtrer spatialement certaines composantes de l'onde enrichie. La configuration de mesure a une influence sur les composantes présentes dans l'onde enrichie incidente sur le récepteur. Pour mesurer la puissance d'une composante d'intermodulation déterminée, une configuration de mesure déterminée est choisie, dans laquelle les composantes fondamentales et les composantes d'intermodulation d'ordre inférieur à ladite composante d'intermodulation déterminée sont de puissance très inférieure à la puissance de ladite composante d'intermodulation déterminée dans l'onde enrichie incidente sur le récepteur. Avantageusement, dans un procédé selon l'invention, au moins une série de mesures est réalisée, correspondant à la production d'une pluralité de signaux de mesure par ledit récepteur, chaque signal de mesure étant représentatif de la puissance d'au moins une composante de l'onde enrichie incidente sur ledit récepteur.

Avantageusement et selon l'invention, plusieurs signaux de mesure sont produits pour une configuration de mesure et sont représentatifs de la puissance d'une pluralité de composantes de l'onde enrichie.

Avantageusement et selon l'invention, un signal de mesure représentatif de la puissance d'au moins une composante de l'onde enrichie est produit pour deux configurations de mesure distinctes. Plusieurs signaux de mesure sont ainsi produits pour plusieurs configurations de mesure distinctes et chaque signal de mesure est représentatif de la puissance d'au moins une même composante de l'onde enrichie pour ces différentes configurations de mesure.

Il est ainsi possible, grâce à un procédé selon l'invention, de réaliser une cartographie de puissance d'une ou plusieurs composantes d'une onde enrichie en composantes d'intermodulation.

Avantageusement et selon l'invention, une étape équivalente au déplacement d'un récepteur selon une direction distincte de la direction de propagation de l'onde enrichie pour réaliser une série de mesures, est réalisée par la production d'une pluralité de signaux de mesures par une pluralité de récepteurs disposés dans le champ de l'onde enrichie, chaque récepteur étant disposé selon une configuration de mesure fixe distincte de la configuration de mesure des autres récepteurs. En particulier, une pluralité de récepteurs selon l'invention sont reliés entre eux, et/ou à un centre collecteur de signaux de mesures de façon à former un réseau de récepteurs. Ainsi, par exemple, dans un procédé selon l'invention, il est possible d'envisager que chaque récepteur produise un signal de mesure représentatif de la puissance d'une composante de l'onde réfléchie, les autres récepteurs produisant un signal de mesure représentatif de la puissance d'une autre composante de l'onde réfléchie.

Ainsi, dans certains modes de réalisation selon l'invention chaque récepteur est fixe dans un référentiel - notamment le référentiel terrestre - et ledit objet non-linéaire et/ou un réflecteur, dit réflecteur pivotant, est pivotant autour d'au moins un axe dans ce même référentiel. Rien n'empêche de prévoir de mettre en œuvre l'invention dans d'autres référentiels, tels qu'un bâti d'une chambre anéchoïque par exemple.

En particulier, le réflecteur pivotant est motorisé en rotation autour d'au moins un axe et sa position angulaire autour de cet axe est commandée.

En particulier, dans ces modes de réalisation, le dernier réflecteur sur le chemin de l'onde électromagnétique entre lesdites sources et chaque récepteur, est monté mobile en rotation autour d'au moins un axe. Avantageusement, seul le dernier réflecteur sur le chemin de l'onde électromagnétique entre lesdites sources et chaque récepteur, est monté mobile en rotation autour d'au moins un axe. C'est donc le réflecteur directement en regard d'une antenne du récepteur qui est déplacé en rotation autour d'au moins un axe.

Avantageusement et selon l'invention, au moins un axe de rotation du réflecteur pivotant est vertical, de sorte que la rotation du réflecteur pivotant autour de son axe de rotation entraîne un balayage d'un plan globalement parallèle à la surface terrestre par l'onde enrichie, le récepteur se trouvant avantageusement dans un secteur angulaire ainsi balayé par l'onde enrichie.

De plus, avantageusement et selon l'invention, ledit réflecteur pivotant est déplacé en rotation autour d'au moins deux axes distincts par rapport audit récepteur.

Les inventeurs ont constaté que les produits d'intermodulation ne sont pas nécessairement tous émis par l'objet non-linéaire dans un plan d'incidence de l'onde enrichie sur ledit objet non-linéaire. Par conséquent, un filtrage spatial par rotation du réflecteur pivotant autour d'un second axe est particulièrement avantageux.

Le réflecteur pivotant permet de balayer, avec l'onde enrichie, au moins un secteur angulaire d'espace selon un plan globalement parallèle à la surface terrestre, et au moins un secteur angulaire d'espace selon un plan globalement perpendiculaire à la surface terrestre. Plus particulièrement, avantageusement et selon l'invention, le premier axe de rotation du réflecteur pivotant et le deuxième axe de rotation du réflecteur pivotant sont orthogonaux entre eux. Avantageusement et selon l'invention le premier axe de rotation du réflecteur pivotant est un axe vertical, et le deuxième axe de rotation du réflecteur pivotant est horizontal.

De telles rotations permettent notamment de mieux caractériser les produits d'intermodulation produits par un objet non-linéaire soumis à une onde électromagnétique multifréquentielle et multisources : en particulier la puissance et la direction des produits d'intermodulation introduits dans l'onde émise par un tel objet.

Alternativement ou en combinaison, dans d'autres modes de réalisation selon l'invention, le récepteur (en particulier une antenne du récepteur) est déplacé selon au moins une direction distincte de la direction de propagation de l'onde enrichie.

Le récepteur est avantageusement déplacé en translation selon une direction orthogonale à la direction de propagation de l'onde enrichie.

En particulier, le récepteur est avantageusement déplacé dans un plan globalement perpendiculaire à la direction de propagation de l'onde, de façon à réaliser une série de mesures à des configurations de mesure distinctes et ainsi réaliser une cartographie de la puissance d'au moins une composante d'intermodulation, avantageusement de plusieurs composantes d'intermodulation, et le cas échéant des composantes fondamentales.

L'objet non-linéaire est par exemple choisi parmi un échantillon de matériau et un réflecteur non-linéaire. Le réflecteur non-linéaire peut par exemple être recouvert d'un matériau non-linéaire ou constitué d'un tissu de fibres de carbone. Un tel réflecteur est par exemple de forme parabolique ou parabolique conformé.

Avantageusement, l'objet non-linéaire est disposé à proximité de la première source et de la deuxième source.

En particulier, dans un dispositif expérimental, lorsque l'objet non-linéaire est de type parabolique (ou parabolique conformé), les sources sont avantageusement disposées près du foyer à une distance du foyer inférieure à la distance focale de façon à favoriser la focalisation des différentes composantes.

Avantageusement, dans un procédé selon l'invention, l'objet non-linéaire reçoit directement l'onde émise par les sources, et la renvoie sous forme d'onde enrichie en composantes d'intermodulation vers un réflecteur qui réfléchit cette onde enrichie vers ledit récepteur. Ledit réflecteur est avantageusement un réflecteur pivotant.

Avantageusement et selon l'invention, les sources, l'objet non-linéaire et un réflecteur parabolique conformé sont disposés de sorte que chaque source fictive des composantes fondamentales est à proximité du foyer dudit réflecteur parabolique conformé.

Par ailleurs, avantageusement et selon l'invention, la première source et la deuxième source sont solidaires en rotation dudit objet de sorte que la position relative de chaque source par rapport audit objet est constante.

Avantageusement et selon l'invention, alternativement ou en combinaison, la première source et la deuxième source sont solidaires en rotation dudit réflecteur de sorte que la position relative de chaque source par rapport audit réflecteur est constante.

Plus particulièrement, avantageusement et selon l'invention, chaque source est déplacée solidairement en rotation avec ledit objet non-linéaire et ledit réflecteur parabolique conformé.

Ainsi, par une rotation du réflecteur pivotant autour d'au moins un axe par rapport au récepteur, lesdites sources sont simultanément déplacées - de façon solidaire avec ledit réflecteur pivotant - de sorte qu'elles conservent, ainsi que les sources fictives des composantes fondamentales et d'intermodulation, leur position proche du foyer dudit réflecteur pivotant parabolique, et que la forme de l'onde enrichie est identique quelle que soit la position angulaire du réflecteur pivotant.

Avantageusement et selon l'invention, les sources sont disposées par rapport au réflecteur pivotant de sorte que chaque source fictive - généralement d'origine(s) distincte(s) des sources réelles de composantes fondamentales - des composantes d'intermodulation est disposée à une distance du foyer dudit réflecteur pivotant parabolique adaptée pour que l'onde enrichie émise par le réflecteur pivotant parabolique puisse être considérée comme focalisée par le réflecteur, au moins lors de sa réception par un récepteur. Les sources réelles (des composantes fondamentales) et les sources fictives (des composantes d'intermodulation) sont ainsi toutes disposées à proximité du foyer du réflecteur pivotant parabolique.

L'invention s'étend également à un dispositif adapté pour pouvoir mettre en œuvre un procédé selon l'invention.

L'invention s'étend notamment à un dispositif de mesure de puissance de produits d'intermodulation produits par réflexion d'onde électromagnétique sur un objet non-linéaire, comprenant :
- une première source électromagnétique adaptée pour émettre une première onde électromagnétique comprenant au moins une composante, dite première composante fondamentale, à partir d'un premier foyer,
- une deuxième source électromagnétique adaptée pour émettre une deuxième onde électromagnétique comprenant au moins une composante, dite deuxième composante fondamentale, à partir d'un deuxième foyer distinct du premier foyer,
   lesdites première onde électromagnétique et deuxième onde électromagnétique formant ensemble une onde électromagnétique, dite onde émise,
- ledit objet non-linéaire, disposé de façon à pouvoir réfléchir ladite onde émise et l'enrichir en composantes, dites composantes d'intermodulation, correspondant à des produits d'intermodulation produits par ledit objet non-linéaire à partir desdites première composante fondamentale et deuxième composante fondamentale,
ledit dispositif étant caractérisé en ce qu'il comprend au moins un élément mobile choisi parmi :
- ledit objet, mobile en rotation autour d'au moins un axe par rapport audit récepteur, au moins entre une première position et une deuxième position,
- un réflecteur adapté pour réfléchir une onde électromagnétique sans l'enrichir en composantes, mobile en rotation autour d'au moins un axe par rapport audit récepteur, au moins entre une première position et une deuxième position,
- ledit récepteur, mobile en translation selon au moins une direction distincte d'une direction d'incidence de ladite onde enrichie sur ledit récepteur, au moins entre une première position et une deuxième position,
et en ce que ledit récepteur est adapté pour produire au moins un signal, dit signal de mesure, représentatif au moins de la puissance d'au moins une composante de l'onde enrichie, pour ladite première position et au moins un signal de mesure pour ladite deuxième position.

En particulier l'invention s'étend à un dispositif de mesure de puissance de produits d'intermodulation produits par réflexion d'onde électromagnétique sur un objet non-linéaire, comprenant :
- une première source électromagnétique adaptée pour émettre à partir d'un premier foyer une première onde électromagnétique comprenant au moins une composante, dite première composante fondamentale,
- une deuxième source électromagnétique adaptée pour émettre à partir d'un deuxième foyer distinct du premier foyer une deuxième onde électromagnétique comprenant au moins une composante, dite deuxième composante fondamentale,
- un objet non-linéaire disposé de façon à pouvoir être irradié par lesdites première composante fondamentale et deuxième composante fondamentale, et à former une onde électromagnétique, dite onde enrichie, comprenant ladite première composante fondamentale, ladite deuxième composante fondamentale et des composantes, dites composantes d'intermodulation,
- un dispositif de réception électromagnétique adapté pour produire au moins un signal, dit signal de mesure, représentatif au moins de la puissance d'au moins une composante d'une onde électromagnétique reçue par ce dispositif de réception,
le dispositif de mesure étant agencé dans au moins une configuration spatiale, dite configuration de mesure, adaptée pour que ladite onde enrichie se propage au moins pour partie jusqu'au dispositif de réception,
caractérisé en ce que, l'onde enrichie ayant une composition variable dans l'espace, il est adapté pour pouvoir changer de configuration de mesure entre une première configuration spatiale, dite première configuration de mesure, dans laquelle le dispositif de réception reçoit une première partie ayant une première composition de l'onde enrichie, et au moins une deuxième configuration spatiale, dite deuxième configuration de mesure, distincte de ladite première configuration de mesure, dans laquelle ledit dispositif de réception produit au moins un deuxième signal de mesure dans laquelle le dispositif de réception reçoit une deuxième partie ayant une deuxième composition de l'onde enrichie distincte de la première composition de l'onde enrichie.

Un dispositif selon l'invention est aussi caractérisé en ce qu'il comprend en outre :
- un dispositif, dit dispositif de positionnement, adapté pour produire des données, dites données de position, numériques représentatives de la configuration de mesure,
- une unité de traitement de données adaptée pour pouvoir, pour toute configuration de mesure, recevoir et enregistrer dans une mémoire des données de position de façon corrélée avec des données, dites données de mesure, numériques représentatives d'au moins un signal de mesure produit par ledit récepteur pour une configuration de mesure dans laquelle lesdites données de position ont été produites.

Ainsi, chaque signal de mesure est associé à une configuration de mesure, ce qui permet de caractériser l'objet non-linéaire. En effet, grâce à un dispositif selon l'invention, dans un procédé conforme à l'invention, la puissance d'au moins une composante d'intermodulation est mesurée et est associée à une configuration de mesure, permettant ainsi de déterminer la direction et la puissance des composantes d'intermodulation introduites par un objet non-linéaire dans une onde électromagnétique à au moins deux composantes.

De plus, avantageusement, dans un dispositif selon l'invention, la première source et la deuxième source sont montées solidaires en rotation dudit objet non-linéaire.

De plus, avantageusement, dans un dispositif selon l'invention, la première source et la deuxième source sont montées solidaires en rotation dudit élément mobile, monté en rotation autour d'au moins un axe, ledit élément mobile étant soit l'objet non-linéaire, soit un réflecteur interposé sur le chemin de l'onde enrichie entre l'objet non-linéaire et le récepteur.

Avantageusement, un dispositif selon l'invention comprend uniquement ledit objet non-linéaire disposé sur le chemin de l'onde émise entre les sources et le récepteur, et un réflecteur pivotant disposé sur le chemin de l'onde enrichie entre l'objet non-linéaire et le récepteur.

Ledit réflecteur pivotant, l'objet non-linéaire et les sources sont avantageusement montés solidaires en rotation, de sorte que leur configuration spatiale relative est constante pour toute position angulaire du réflecteur pivotant.

Par ailleurs, avantageusement et selon l'invention, la distance entre le récepteur et le dernier réflecteur du dispositif de guidage est supérieure au diamètre de ce réflecteur divisé par la tangente de l'angle entre les directions des ondes aux fréquences fondamentales (soit 57 fois le diamètre pour un angle de 1° et 573 fois le diamètre pour un angle de 0,1°). Il est ainsi possible d'utiliser une installation existante de base de mesure d'antenne d'une longueur de quelques dizaines à quelques centaines de mètres ou plus.

L'invention concerne également un procédé et un dispositif caractérisés en combinaison par tout ou partie des caractéristiques mentionnées ci-dessus ou ci-après.

D'autres buts, caractéristiques et avantages de l'invention apparaîtront à la lecture de la description suivante donnée à titre non limitatif et qui se réfère aux figures annexées dans lesquelles :
- la figure 1 est une représentation schématique d'un dispositif de mesure de puissance de produits d'intermodulation produits par réflexion d'onde sur un objet non-linéaire au moins partiellement réfléchissant, permettant de mettre en œuvre un procédé selon l'invention, selon un premier mode de réalisation conforme à l'invention,
- la figure 2 est une représentation schématique d'un dispositif de mesure de puissance de produits d'intermodulation produits par réflexion d'onde sur un objet non-linéaire au moins partiellement réfléchissant, permettant de mettre en œuvre un procédé selon l'invention, selon un deuxième mode de réalisation conforme à l'invention,
- la figure 3 est une représentation schématique d'un dispositif conforme à la figure 1 dans lequel le récepteur est mobile,
- la figure 4 est une représentation schématique d'un dispositif conforme à la figure 1,
- la figure 5 est une représentation schématique d'un dispositif conforme à la figure 2.

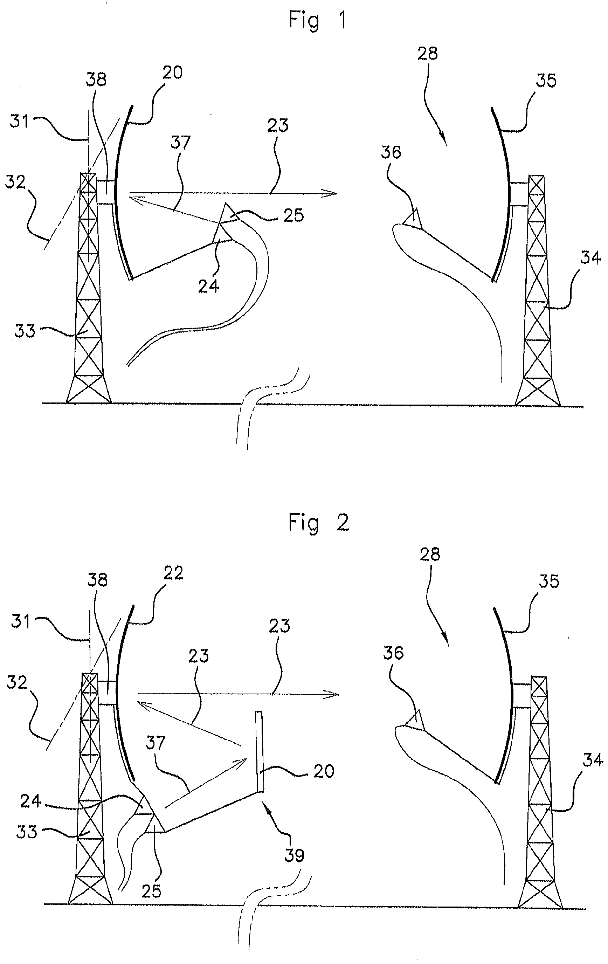

Dans un dispositif selon l'invention tel que représenté à la figure 1, une première source 24 électromagnétique et une deuxième source 25 électromagnétique sont disposées avec des foyers distincts en regard d'un réflecteur 20.

La première source 24 émet une onde électromagnétique comprenant au moins une première composante, dite composante fondamentale, de fréquence f1. La deuxième source 25 émet une onde électromagnétique comprenant au moins une deuxième composante fondamentale de fréquence f2 distincte ou non de la fréquence f1.

Ainsi, une onde électromagnétique, dite onde émise 37, constituée des ondes électromagnétiques émises par la première source et par la deuxième source - donc comprenant au moins une composante fondamentale de fréquence f1 et une composante fondamentale de fréquence f2 - est émise en direction du réflecteur 20.

Dans le mode de réalisation représenté en figure 1, le réflecteur est par exemple de forme parabolique conformée.

Le réflecteur 20 est dans un matériau ou est recouvert d'un matériau dont le comportement électromagnétique doit être testé. Il constitue donc l'objet non-linéaire 20 au moins partiellement réfléchissant d'ondes électromagnétiques, qui crée des produits d'intermodulation à partir des composantes fondamentales de l'onde émise 37.

Des composantes d'intermodulation sont donc ajoutées par le réflecteur 20 à l'onde émise 37 incidente sur ledit réflecteur 20, de sorte qu'une onde électromagnétique, dite onde enrichie 23, comprenant lesdites composantes fondamentales et des composantes d'intermodulation est renvoyée par le réflecteur 20.

Le réflecteur 20 est monté articulé en rotation sur un pylône 33, autour de deux axes 31, 32 distincts orthogonaux. Le réflecteur 20 est pivotant autour d'un axe vertical 31 et pivotant autour d'un axe horizontal 32.

La position angulaire du réflecteur 20 autour de chaque axe est avantageusement mesurée par un dispositif, dit dispositif de positionnement 38, adapté pour produire des données, dites données de position, numériques représentatives de sa position angulaire autour de chaque axe 31, 32.

La rotation du réflecteur 20 autour des deux axes est avantageusement motorisée par le dispositif de positionnement 38.

Les sources 24, 25 sont montées solidaires en rotation du réflecteur 20.

Le réflecteur 20 est avantageusement orienté de sorte qu'au moins une partie de l'onde enrichie 23 est émise en direction d'un récepteur 28.

Ledit récepteur comprend une antenne 35 de réception, montée fixe sur un pylône 34. Ledit récepteur 28 comprend un organe de réception 36 adapté pour transformer une portion incidente sur ladite antenne 35 de l'onde enrichie 23, en signaux électriques - analogiques ou numériques - représentatifs au moins de la puissance d'une pluralité des composantes (avantageusement chaque composante) contenue dans ladite portion incidente de onde enrichie 23.

Le réflecteur 20 est monté rotatif autour de l'axe vertical 31 pour pouvoir balayer un secteur angulaire d'espace dans un plan horizontal, et autour de l'axe horizontal 32 pour pouvoir balayer un secteur angulaire d'espace dans un plan vertical.

Le dispositif comprend en outre une unité de traitement de données (non représentée) qui enregistre en mémoire la puissance de chaque composante mesurée de l'onde enrichie 23 reçue par ledit récepteur 28 pour une position angulaire donnée du réflecteur 20. Dans un procédé selon l'invention, cette opération est répétée pour une pluralité de positions angulaires distinctes du réflecteur 20. Avantageusement, la même unité de traitement contrôle la position angulaire du réflecteur 20 ; elle envoie notamment des signaux de commande au dispositif de positionnement 38.

Ainsi un dispositif et un procédé selon l'invention permettent de déterminer la puissance de chaque composante d'intermodulation émise par un objet non-linéaire 20. En particulier, elle permet de mesurer la puissance de composantes d'intermodulation de façon fiable et précise, en filtrant spatialement les composantes fondamentales et des composantes d'intermodulation de rang plus petit (donc de puissance plus élevée), par une simple rotation du réflecteur 20.

Un second mode de réalisation de l'invention est présenté en figure 2.

L'émetteur 39 comprend un réflecteur parabolique 22, adapté pour réfléchir sensiblement fidèlement une onde électromagnétique - notamment pour réfléchir une onde électromagnétique sans substantiellement y introduire de composante d'intermodulation. Comme dans le premier mode de réalisation présenté en figure 1, le réflecteur parabolique 22 est motorisé en rotation autour d'un axe vertical 31 et d'un axe horizontal 32.

Les sources 24, 25 d'émission d'une onde émise 37 comprenant au moins deux composantes fondamentales sont disposées en regard d'un objet non-linéaire 20. Les sources 24, 25 et l'objet non-linéaire 20 sont disposés de sorte que l'onde émise 37 est au moins partiellement réfléchie par ledit objet non-linéaire 20 en direction du réflecteur parabolique 22.

L'objet non-linéaire 20 est un échantillon d'un matériau dont le comportement doit être testé. L'objet non-linéaire 20 introduit des composantes d'intermodulation dans l'onde émise 37 incidente issue des sources 24, 25. L'objet non-linéaire 20 réémet une onde électromagnétique, dite onde enrichie 23, comprenant les composantes fondamentales et des composantes d'intermodulation en direction du réflecteur 22.

Les sources 24, 25 et l'objet non-linéaire 20 sont montés solidaires en rotation du réflecteur parabolique 22.

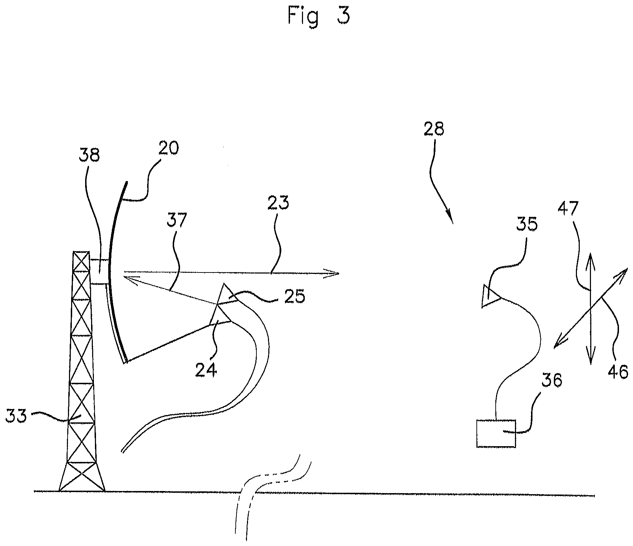

Un troisième mode de réalisation de l'invention est présenté en figure 3.

Ce mode de réalisation est en tous points identique au premier mode de réalisation correspondant à la figure 1, à l'exception que :
- l'objet non-linéaire 20 et les sources sont fixes,
- le récepteur 28 est mobile, notamment mobile en translation.

Le récepteur 28 comprend une antenne 35 de réception et un organe de réception 36 adapté pour transformer une portion incidente sur ladite antenne 35 de l'onde enrichie 23, en signaux électriques - analogiques ou numériques - représentatifs au moins de la puissance d'une pluralité des composantes (avantageusement chaque composante) contenue dans ladite portion incidente de onde enrichie 23.

Le récepteur 28 est avantageusement déplacé, dans un procédé conforme à l'invention, par une translation selon au moins une première direction 46 sensiblement localement parallèle à la surface terrestre et orthogonale à la direction de propagation de l'onde enrichie 23.

Le récepteur 28 est avantageusement aussi mobile selon une deuxième direction 47 sensiblement localement verticale à la surface terrestre et orthogonale à la direction de propagation de l'onde enrichie 23.

Ainsi, une série de mesures peut être réalisée pour différentes positions du récepteur, permettant en particulier à certaines positions de mesurer la puissance d'au moins une composante d'intermodulation sans être gêné par la puissance d'une composante fondamentale.

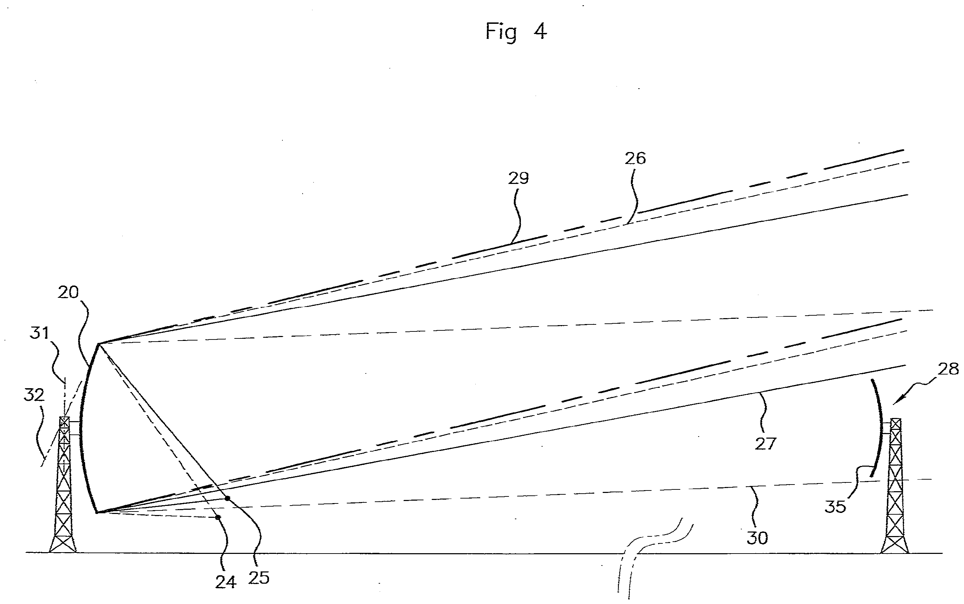

En figure 4, le dispositif selon le premier mode de réalisation présenté en figure 1 est représenté dans une configuration de mesure, c'est-à-dire avec une position angulaire déterminée du réflecteur 20.

La première source 24 émet une composante fondamentale unique de fréquence f1, et la deuxième source 25 émet une composante fondamentale unique de fréquence f2. L'enveloppe des composantes fondamentales est représentée en coupe longitudinale. Plus particulièrement, l'enveloppe 26 de la composante de fréquence f1 est représentée en traits pointillés, et l'enveloppe 27 de la composante de fréquence f2 est représentée en traits pleins.

En outre, les enveloppes de deux composantes d'intermodulation créées par l'objet non-linéaire sous forme de réflecteur 20 parabolique conformé sont aussi représentées en coupe longitudinale. Ainsi, les enveloppes des composantes d'intermodulation d'ordre 3 : l'enveloppe 29 d'une composante de fréquence f3a=2f1-f2 et l'enveloppe 30 d'une composante de fréquence f3b=2f2-f1, sont représentées.

Le réflecteur 20 est représenté dans une position angulaire adaptée pour permettre de filtrer les composantes de fréquences f1, f2 et f3a de l'onde enrichie 23 incidente sur l'antenne 35 du récepteur 28, tandis que la composante d'intermodulation de fréquence f3b est incidente sur l'antenne 35 du récepteur 28.

En effet, la composante d'intermodulation de fréquence f3b est émise par l'objet 20 dans une direction légèrement distincte des directions prises par les autres composantes de l'onde enrichie 23.

Toutes les composantes de fréquences de l'onde 23 ont des puissances compatibles avec la dynamique du récepteur à cette position angulaire du réflecteur 20, et les composantes d'intermodulation d'ordre supérieur à la composante d'intermodulation de fréquence f3b peuvent être facilement séparées de la composante de fréquence f3b qui est plus puissante que les composantes d'ordre supérieur.

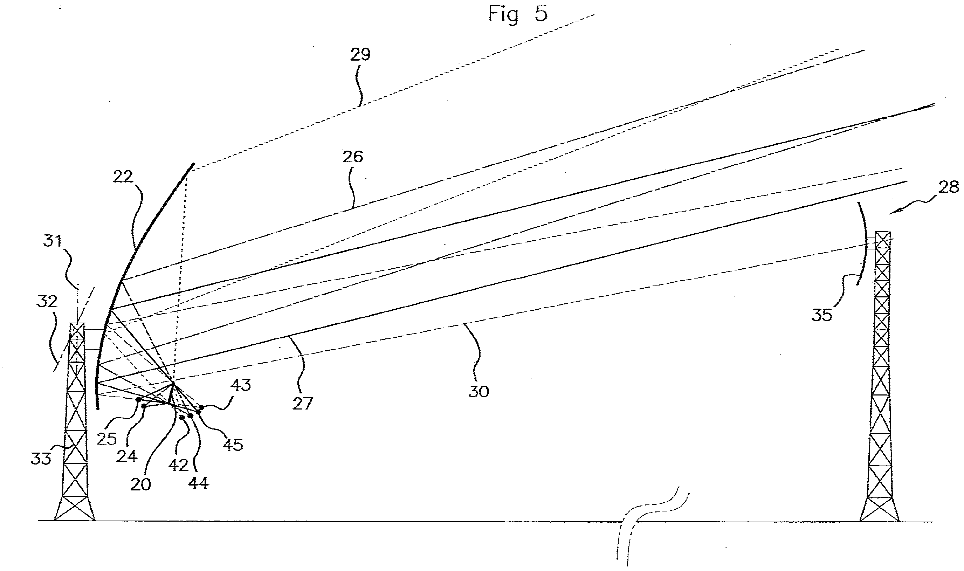

En figure 5, le dispositif selon le deuxième mode de réalisation présenté en figure 2 est représenté dans une configuration de mesure, c'est-à-dire avec une position angulaire déterminée du réflecteur 22.

La première source 24 émet une composante fondamentale unique de fréquence f1, et la deuxième source 25 émet une composante fondamentale unique de fréquence f2. L'enveloppe des composantes fondamentales est représentée en coupe longitudinale. Plus particulièrement, l'enveloppe 26 de la composante de fréquence f1 et l'enveloppe 27 de la composante de fréquence f2 sont représentées en traits mixtes pointillés et, respectivement en traits pleins.

Les sources 24, 25 émettent une onde électromagnétique, dite onde émise 37, en direction d'un échantillon d'objet non-linéaire 20, ce dernier réfléchissant l'onde émise 37, enrichie en composantes d'intermodulation vers le réflecteur 22 parabolique conformé.

Les enveloppes de quatre composantes d'intermodulation créées par l'objet non-linéaire 20 sont aussi représentées en coupe longitudinale.

Ainsi, les enveloppes des composantes d'intermodulation d'ordre 3 : l'enveloppe 29 d'une composante de fréquence f3a=2f1-f2 et l'enveloppe 30 d'une composante de fréquence f3b=2f2-f1, sont représentées en traits pointillés.

Par symétrie par rapport à l'objet non-linéaire 20, les composantes fondamentales et les composantes d'intermodulation parviennent sur le réflecteur 22 de sources fictives.

Ainsi, les sources fictives 42, 43, 44, 45 respectivement de la composante d'intermodulation de fréquence f3a, de la composante d'intermodulation de fréquence f3b, de la composante fondamentale de fréquence f1, et de la composante fondamentale de fréquence f2, sont représentées en figure 5. Les sources 24, 25 sont disposées par rapport à l'objet non-linéaire 20 de sorte que leurs sources fictives 44, 45 sont à proximité du foyer du réflecteur 22 parabolique.

D'autres composantes d'intermodulation de même ordre existent, par exemple à l'ordre 3 f3c=2f2+f1, f3d=2f1+f2, ou par exemple à l'ordre 5 de fréquence f5c=4fl-f2, f5d=4f2-f1, f5e=3f1+2f2, etc. Le réflecteur 22 est représenté dans une position angulaire adaptée pour permettre de filtrer les composantes de fréquences f1, f2 et f3a de l'onde enrichie 23 incidente sur l'antenne 35 du récepteur 28, tandis que la composante d'intermodulation de fréquence f3b est incidente sur l'antenne 35 du récepteur 28.

En effet, la composante d'intermodulation de fréquence f3b est émise par l'objet non-linéaire 20 dans une direction légèrement distincte des directions prises par les autres composantes de l'onde enrichie 23, en particulier, elle est réémise avec un angle de réflexion inférieur aux angles de réflexion des composantes fondamentales et de la deuxième composante d'ordre 3 (de fréquence f3a).

Seules des composantes d'intermodulation d'ordre supérieur à la composante d'intermodulation de fréquence f3b sont donc susceptibles d'être incidentes sur le récepteur. Elles peuvent facilement être séparées de la composante de fréquence f3b qui est la composante la plus puissante.

Le déplacement du réflecteur 22 en rotation autour de l'axe 32 horizontal dans un premier sens permet d'éliminer cette composante d'intermodulation de fréquence f3b et de pouvoir mesurer la puissance de composantes d'intermodulation d'ordre supérieur (5, 7, 9, etc.). Le déplacement du réflecteur 22 en rotation autour de l'axe 32 horizontal dans un deuxième sens opposé au premier sens permet de retrouver une puissance non-nulle pour la composante fondamentale de fréquence f2, puis une puissance non-nulle pour la composante fondamentale de fréquence f1, puis une puissance non-nulle pour la composante d'intermodulation de fréquence f3a.

En éloignant le récepteur 28 suffisamment du réflecteur pivotant 22, il est possible de mesurer la puissance d'une unique composante (fondamentale ou d'intermodulation) à la fois.

L'invention peut faire l'objet de nombreuses autres variantes de réalisation non représentées.

En particulier, le nombre de réflecteurs sur le chemin de l'onde électromagnétique entre les sources et chaque récepteur peut être différent, notamment supérieur à un ou deux.

En outre, le nombre de sources peut être supérieur à deux.

De même, le nombre de composantes fondamentales dans l'onde émise (avant incidence sur l'objet non-linéaire) peut être supérieur à deux, et/ou le nombre de composantes fondamentales émises par chaque source peut être supérieur à une.

Rien n'empêche non plus, de prévoir un organe de réception disposé à proximité des sources afin de mesurer la puissance de chaque composante de l'onde émise réfléchie directement en direction des sources.

## Revendications

1. Procédé de mesure de puissance de produits d'intermodulation produits par réflexion d'une onde électromagnétique sur un objet non-linéaire (20), dans lequel on utilise un dispositif de mesure comprenant :
- une première source (24) électromagnétique émettant à partir d'un premier foyer une première onde électromagnétique comprenant au moins une composante, dite première composante fondamentale (26),
- une deuxième source (25) électromagnétique émettant à partir d'un deuxième foyer distinct du premier foyer, une deuxième onde électromagnétique comprenant au moins une composante, dite deuxième composante fondamentale (27),
- un objet non-linéaire (20) disposé de façon à pouvoir être irradié par lesdites première composante fondamentale et deuxième composante fondamentale, et à former une onde électromagnétique, dite onde enrichie (23), comprenant ladite première composante fondamentale, ladite deuxième composante fondamentale et des composantes, dites composantes d'intermodulation (29, 30),
- un dispositif de réception (28) électromagnétique adapté pour produire au moins un signal, dit signal de mesure, représentatif au moins de la puissance d'au moins une composante d'une onde électromagnétique reçue par ce dispositif de réception (28),
- le dispositif de mesure étant agencé dans au moins une configuration spatiale, dite configuration de mesure, dans laquelle ladite onde enrichie (23) se propage au moins pour partie jusqu'au dispositif de réception (28),
**caractérisé en ce que**, l'onde enrichie ayant une composition variable dans l'espace, il comprend :
- une première étape de mesure dans laquelle le dispositif de mesure est agencé dans une première configuration spatiale, dite première configuration de mesure, adaptée pour que ledit dispositif de réception (28) produise au moins un premier signal de mesure pour une première partie ayant une première composition de l'onde enrichie (23),
- et au moins une deuxième étape de mesure dans laquelle le dispositif de mesure est agencé dans une deuxième configuration spatiale, dite deuxième configuration de mesure, distincte de ladite première configuration de mesure, adaptée pour que ledit dispositif de réception (28) produise au moins un deuxième signal de mesure pour une deuxième partie ayant une deuxième composition de l'onde enrichie (23) distincte de la première composition de l'onde enrichie (23).

2. Procédé selon la revendication 1, **caractérisé en ce qu'**il comprend en outre une étape de modification de la configuration de mesure de ladite première configuration de mesure à ladite deuxième configuration de mesure, cette étape de modification étant choisie parmi :
- une étape de déplacement dudit objet non-linéaire (20) en rotation autour d'au moins un axe (31, 32) par rapport audit dispositif de réception (28), au moins entre une première configuration de mesure et une deuxième configuration de mesure,
- une étape de déplacement d'un réflecteur (22) adapté pour réfléchir une onde électromagnétique sans l'enrichir en composantes, en rotation autour d'au moins un axe (31, 32) par rapport audit dispositif de réception (28), au moins entre une première configuration de mesure et une deuxième configuration de mesure, et
- une étape de déplacement dudit dispositif de réception (28) en translation selon au moins une direction distincte d'une direction d'incidence de ladite onde enrichie (23) sur ledit dispositif de réception, au moins entre une première configuration de mesure et une deuxième configuration de mesure,

3. Procédé selon l'une des revendications 1 ou 2, **caractérisé en ce que** :
- la première onde électromagnétique comprend au moins une composante, dite première composante fondamentale (26), à une première fréquence,
- la deuxième onde électromagnétique comprend au moins une composante, dite deuxième composante fondamentale (27), à une deuxième fréquence distincte de la première fréquence.

4. Procédé selon la revendication 3, **caractérisé en ce que** les fréquences desdites première composante fondamentale (26) et deuxième composante fondamentale (27) sont dans le domaine des radiofréquences.

5. Procédé selon l'une des revendications 1 à 4, **caractérisé en ce qu'**au moins un signal de mesure est produit par le dispositif de réception (28) pour au moins une configuration de mesure dans laquelle la puissance de l'onde enrichie (23) est inférieure à la puissance de saturation dudit dispositif de réception (28).

6. Procédé selon l'une des revendications 1 à 5, **caractérisé en ce qu'**au moins un signal de mesure est produit par le dispositif de réception (28) pour une première configuration de mesure dans laquelle le rapport de la puissance d'une première composante d'intermodulation sur la puissance d'une deuxième composante d'intermodulation est inférieur à la dynamique dudit dispositif de réception (28).

7. Procédé selon l'une des revendications 1 à 6, **caractérisé en ce que** l'étape de modification de la configuration du système de transmission comprend au moins une étape de déplacement choisie parmi :
- une étape de déplacement dudit objet non-linéaire (20) en rotation autour d'au moins deux axes distincts par rapport audit dispositif de réception (28),
- une étape de déplacement dudit réflecteur (22) en rotation autour d'au moins deux axes distincts par rapport audit dispositif de réception, et
- une étape de déplacement dudit récepteur (28) en translation selon au moins deux directions distinctes entre elles et distinctes chacune de la direction d'incidence de ladite onde enrichie (23) sur ledit dispositif de réception.

8. Procédé selon l'une des revendications 1 à 7, **caractérisé en ce que** la première source et la deuxième source sont solidaires en rotation dudit objet non-linéaire (20) de sorte que la position relative de chaque source par rapport audit objet non-linéaire (20) est constante.

9. Procédé selon l'une des revendications 1 à 8, **caractérisé en ce que** la première source et la deuxième source sont solidaires en rotation dudit réflecteur (22) de sorte que la position relative de chaque source par rapport audit réflecteur (22) est constante.

10. Dispositif de mesure de puissance de produits d'intermodulation produits par réflexion d'onde électromagnétique sur un objet non-linéaire (20), comprenant :
- une première source (24) électromagnétique adaptée pour émettre à partir d'un premier foyer une première onde électromagnétique comprenant au moins une composante, dite première composante fondamentale (26),
- une deuxième source (25) électromagnétique adaptée pour émettre à partir d'un deuxième foyer distinct du premier foyer une deuxième onde électromagnétique comprenant au moins une composante, dite deuxième composante fondamentale (27),
- un objet non-linéaire (20) disposé de façon à pouvoir être irradié par lesdites première composante fondamentale et deuxième composante fondamentale, et à former une onde électromagnétique, dite onde enrichie (23), comprenant ladite première composante fondamentale, ladite deuxième composante fondamentale et des composantes, dites composantes d'intermodulation (29, 30),
- un dispositif de réception (28) électromagnétique adapté pour produire au moins un signal, dit signal de mesure, représentatif au moins de la puissance d'au moins une composante d'une onde électromagnétique reçue par ce dispositif de réception (28),
le dispositif de mesure étant agencé dans au moins une configuration spatiale, dite configuration de mesure, adaptée pour que ladite onde enrichie (23) se propage au moins pour partie jusqu'au dispositif de réception (28),
**caractérisé en ce que**, l'onde enrichie ayant une composition variable dans l'espace, il est adapté pour pouvoir changer de configuration de mesure entre une première configuration spatiale, dite première configuration de mesure, dans laquelle le dispositif de réception (28) reçoit une première partie ayant une première composition de l'onde enrichie (23), et au moins une deuxième configuration spatiale, dite deuxième configuration de mesure, distincte de ladite première configuration de mesure, et dans laquelle ledit dispositif de réception (28) produit au moins un deuxième signal de mesure dans laquelle le dispositif de réception (28) reçoit une deuxième partie ayant une deuxième composition de l'onde enrichie (23) distincte de la première composition de l'onde enrichie (23).

11. Dispositif selon la revendication 10, **caractérisé en ce qu'**il comprend en outre :
- un dispositif, dit dispositif de positionnement, adapté pour produire des données, dites données de position, numériques représentatives de la configuration de mesure,
- une unité de traitement de données adaptée pour pouvoir, pour toute configuration de mesure, recevoir et enregistrer dans une mémoire des données de position de façon corrélée avec des données, dites données de mesure, numériques représentatives d'au moins un signal de mesure produit par ledit récepteur pour une configuration de mesure dans laquelle lesdites données de position ont été produites.

12. Dispositif selon l'une des revendications 10 ou 11, **caractérisé en ce que** la première source et la deuxième source sont montées solidaires en rotation dudit objet non-linéaire.

## Patentansprüche

1. Verfahren zum Messen der Leistung von Intermodulationsprodukten, erzeugt durch Reflexion einer elektromagnetischen Welle an einem nichtlinearen Objekt (20), bei dem eine Messvorrichtung verwendet wird, umfassend:
- eine erste elektromagnetische Quelle (24), die ab einem ersten Fokus eine erste elektromagnetische Welle sendet, die mindestens eine Komponente, bezeichnet als erste grundlegende Komponente (26), umfasst,
- eine zweite elektromagnetische Quelle (25), die ab einem zweiten Fokus, der sich vom ersten Fokus unterscheidet, eine zweite elektromagnetische Welle sendet, die mindestens eine Komponente, bezeichnet als zweite grundlegende Komponente (27), umfasst,
- ein nichtlineares Objekt (20), das derart angeordnet ist, um von der ersten grundlegenden Komponente und der zweiten grundlegenden Komponente bestrahlt werden zu können, und um eine elektromagnetische Welle, bezeichnet als angereicherte Welle (23), zu bilden, die die erste grundlegende Komponente, die zweite grundlegende Komponente und Komponenten, bezeichnet als Intermodulationskomponenten (29, 30), umfasst,
- eine elektromagnetische Empfangsvorrichtung (28), die zum Erzeugen von mindestens einem Signal, bezeichnet als Messsignal, geeignet ist, das für mindestens die Leistung von mindestens einer Komponente einer elektromagnetischen Welle repräsentativ ist, die von dieser Empfangsvorrichtung (28) empfangen wird,
- wobei die Messvorrichtung in mindestens einer räumlichen Konfiguration, bezeichnet als Messkonfiguration, eingerichtet ist, in welcher sich die angereicherte Welle (23) mindestens zum Teil bis zur Empfangsvorrichtung (28) ausbreitet,
**dadurch gekennzeichnet, dass**, wobei die angereicherte Welle eine variable Zusammensetzung im Raum hat, es umfasst:
- einen ersten Messschritt, bei dem die Messvorrichtung in einer ersten räumlichen Konfiguration, bezeichnet als erste Messkonfiguration, eingerichtet ist, die geeignet ist, damit die Empfangsvorrichtung (28) mindestens ein erstes Messsignal für einen ersten Teil mit einer ersten Zusammensetzung der angereicherten Welle (23) erzeugt,
- und mindestens einen zweiten Messschritt, bei dem die Messvorrichtung in einer zweiten räumlichen Konfiguration, bezeichnet als zweite Messkonfiguration, die sich von der ersten Messkonfiguration unterscheidet, eingerichtet ist, die geeignet ist, damit die Empfangsvorrichtung (28) mindestens ein zweites Messsignal für einen zweiten Teil mit einer zweiten Zusammensetzung der angereicherten Welle (23), die sich von der ersten Zusammensetzung der angereicherten Welle (23) unterscheidet, erzeugt.

2. Verfahren nach Anspruch 1, **dadurch gekennzeichnet, dass** es ferner einen Änderungsschritt der Messkonfiguration der ersten Messkonfiguration in die zweite Messkonfiguration umfasst, wobei dieser Änderungsschritt ausgewählt ist aus:
- einem Rotations-Verlagerungsschritt des nichtlinearen Objekts (20) um mindestens eine Achse (31, 32) im Verhältnis zur Empfangsvorrichtung (28) mindestens zwischen einer ersten Messkonfiguration und einer zweiten Messkonfiguration,
- einem Rotations-Verlagerungsschritt eines Reflektors (22), der zum Reflektieren einer elektromagnetischen Welle geeignet ist, ohne sie mit Komponenten anzureichen, um mindestens eine Achse (31, 32) im Verhältnis zur Empfangsvorrichtung (28) mindestens zwischen einer ersten Messkonfiguration und einer zweiten Messkonfiguration, und
- einem Translations-Verlagerungsschritt der Empfangsvorrichtung (28) gemäß mindestens einer Richtung, die sich von einer Einfallsrichtung der angereicherten Welle (23) auf der Empfangsvorrichtung unterscheidet, mindestens zwischen einer ersten Messkonfiguration und einer zweiten Messkonfiguration.

3. Verfahren nach einem der Ansprüche 1 oder 2, **dadurch gekennzeichnet, dass**:
- die erste elektromagnetische Welle mindestens eine Komponente, bezeichnet als erste grundlegende Komponente (26), in einer ersten Frequenz umfasst,
- die zweite elektromagnetische Welle mindestens eine Komponente, bezeichnet als zweite grundlegende Komponente (27), in einer zweiten Frequenz, die sich von der ersten Frequenz unterscheidet, umfasst.

4. Verfahren nach Anspruch 3, **dadurch gekennzeichnet, dass** die Frequenzen der ersten grundlegenden Komponente (26) und zweiten grundlegenden Komponente (27) im Bereich der Hochfrequenzen sind.

5. Verfahren nach einem der Ansprüche 1 bis 4, **dadurch gekennzeichnet, dass** mindestens ein Messsignal von der Empfangsvorrichtung (28) für mindestens eine Messkonfiguration erzeugt wird, in der die Leistung der angereicherten Welle (23) niedriger als die Sättigungsleistung der Empfangsvorrichtung (28) ist.

6. Verfahren nach einem der Ansprüche 1 bis 5, **dadurch gekennzeichnet, dass** mindestens ein Messsignal von der Empfangsvorrichtung (28) für eine erste Messkonfiguration erzeugt wird, in der das Verhältnis der Leistung einer ersten Intermodulationskomponente zu der Leistung einer zweiten Intermodulationskomponente unter der Dynamik der Empfangsvorrichtung (28) liegt.

7. Verfahren nach einem der Ansprüche 1 bis 6, **dadurch gekennzeichnet, dass** der Änderungsschritt der Konfiguration des Übertragungssystems mindestens einen Verlagerungsschritt umfasst, der ausgewählt ist aus:
- einem Rotations-Verlagerungsschritt des nichtlinearen Objekts (20) um mindestens zwei unterschiedliche Achsen im Verhältnis zur Empfangsvorrichtung (28),
- einem Rotations-Verlagerungsschritt des Reflektors (22) um mindestens zwei unterschiedliche Achsen im Verhältnis zur Empfangsvorrichtung, und
- einem Translations-Verlagerungsschritt des Empfängers (28) gemäß mindestens zwei zueinander unterschiedlichen Richtungen und jeweils unterschiedlich von der Einfallsrichtung der angereicherten Welle (23) auf die Empfangsvorrichtung.

8. Verfahren nach einem der Ansprüche 1 bis 7, **dadurch gekennzeichnet, dass** die erste Quelle und die zweite Quelle mit dem nichtlinearen Objekt (20) rotatorisch fest verbunden sind, so dass die relative Position jeder Quelle im Verhältnis zum nichtlinearen Objekt (20) konstant ist.

9. Verfahren nach einem der Ansprüche 1 bis 8, **dadurch gekennzeichnet, dass** die erste Quelle und die zweite Quelle mit dem Reflektor (22) rotatorisch fest verbunden sind, so dass die relative Position jeder Quelle im Verhältnis zum Reflektor (22) konstant ist.

10. Vorrichtung zum Messen der Leistung von Intermodulationsprodukten, erzeugt durch Reflexion einer elektromagnetischen Welle an einem nichtlinearen Objekt (20), umfassend:
- eine erste elektromagnetische Quelle (24), die geeignet ist, ab einem ersten Fokus eine erste elektromagnetische Welle zu senden, die mindestens eine Komponente, bezeichnet als erste grundlegende Komponente (26), umfasst,
- eine zweite elektromagnetische Quelle (25), die geeignet ist, ab einem zweiten Fokus, der sich vom ersten Fokus unterscheidet, eine zweite elektromagnetische Welle zu senden, die mindestens eine Komponente, bezeichnet als zweite grundlegende Komponente (27), umfasst,
- ein nichtlineares Objekt (20), das derart angeordnet ist, dass es von der ersten grundlegenden Komponente und zweiten grundlegenden Komponente bestrahlt sein kann und eine elektromagnetische Welle, bezeichnet als angereicherte Welle (23), bilden, die die erste grundlegende Komponente, die zweite grundlegende Komponente und Komponenten, bezeichnet als Intermodulationskomponenten (29, 30), umfasst,
- eine elektromagnetische Empfangsvorrichtung (28), die zum Erzeugen von mindestens einem Signal, bezeichnet als Messsignal, geeignet ist, das für mindestens die Leistung von mindestens einer Komponente einer elektromagnetischen Welle repräsentativ ist, die von dieser Empfangsvorrichtung (28) empfangen wird,
wobei die Messvorrichtung in mindestens einer räumlichen Konfiguration, bezeichnet als Messkonfiguration, eingerichtet ist, die geeignet ist, damit sich die angereicherte Welle (23) mindestens zum Teil bis zur Empfangsvorrichtung (28) ausbreitet,
**dadurch gekennzeichnet, dass**, wobei die angereicherte Welle eine variable Zusammensetzung im Raum hat, sie geeignet ist, die Messkonfiguration zwischen einer ersten räumlichen Konfiguration, bezeichnet als erste Messkonfiguration, in der die Empfangsvorrichtung (28) einen ersten Teil mit einer ersten Zusammensetzung der angereicherten Welle (23) empfängt, und mindestens einer zweiten räumlichen Konfiguration, bezeichnet als zweite Messkonfiguration, die sich von der ersten Messkonfiguration unterscheidet und in der die Empfangsvorrichtung (28) mindestens ein zweites Messsignal erzeugt, wechseln zu können, in der die Empfangsvorrichtung (28) einen zweiten Teil mit einer zweiten Zusammensetzung der angereicherte Welle (23) empfängt, die sich von der ersten Zusammensetzung der angereicherten Welle (23) unterscheidet.

11. Vorrichtung nach Anspruch 10, **dadurch gekennzeichnet, dass** sie ferner umfasst:
- eine Vorrichtung, bezeichnet als Positionierungsvorrichtung, die geeignet ist, digitale Daten, bezeichnet als Positionsdaten, zu erzeugen, die für die Messkonfiguration repräsentativ sind,
- eine Datenverarbeitungseinheit, die geeignet ist, für jede Messkonfiguration Positionsdaten in einem Datenspeicher mit anderen digitalen Daten, bezeichnet als Messdaten, zu empfangen und korreliert zu speichern, die für mindestens ein Messsignal repräsentativ sind, das von dem Empfänger für eine Messkonfiguration erzeugt wird, in der die Positionsdaten erzeugt wurden.

12. Vorrichtung nach einem der Ansprüche 10 oder 11, **dadurch gekennzeichnet, dass** die erste Quelle und die zweite Quelle mit dem nichtlinearen Objekt rotatorisch fest verbunden angebracht sind.

## Claims

1. A method of measuring power of intermodulation products produced by reflection of an electromagnetic wave on a non-linear object (20), wherein a measuring device is used, comprising:
- a first electromagnetic source (24) emitting from a first focus a first electromagnetic wave comprising at least one component, called first fundamental component (26),
- a second electromagnetic source (25) emitting from a second focus distinct from the first focus, a second electromagnetic wave comprising at least one component, called second fundamental component (27),
- a non-linear object (20) disposed so as to be able to be irradiated by said first fundamental component and second fundamental component, and to form an electromagnetic wave, called enriched wave (23), comprising said first fundamental component, said second fundamental component and components, called intermodulation components (29, 30),
- an electromagnetic receiving device (28) adapted to produce at least one signal, called measurement signal, representative of at least the power of at least one component of an electromagnetic wave received by this receiving device (28),
- the measuring device being arranged in at least one spatial configuration, called measuring configuration, in which said enriched wave (23) propagates at least in part up to the receiving device (28),
**characterized in that**, the enriched wave having a space-variable composition, it comprises:
- a first measuring step in which the measuring device is arranged in a first spatial configuration, called first measuring configuration, adapted such that said receiving device (28) produces at least one first measurement signal for a first portion having a first composition of the enriched wave (23),
- and at least one second measuring step in which the measuring device is arranged in a second spatial configuration, called second measuring configuration, distinct from said first measuring configuration, adapted such that said receiving device (28) produces at least one second measurement signal for a second portion having a second composition of the enriched wave (23) distinct from the first composition of the enriched wave (23).

2. The method according to claim 1, **characterized in that** it further comprises a step of modifying the measuring configuration from said first measuring configuration to said second measuring configuration, this modification step being selected from:
- a step of displacing said non-linear object (20) in rotation about at least one axis (31, 32) relative to said receiving device (28), at least between a first measuring configuration and a second measuring configuration,
- a step of displacing a reflector (22) adapted to reflect an electromagnetic wave without enriching it with components, in rotation about at least one axis (31, 32) relative to said receiving device (28), at least between a first measuring configuration and a second measuring configuration, and
- a step of displacing said receiving device (28) in translation along at least one direction distinct from a direction of incidence of said enriched wave (23) on said receiving device, at least between a first measuring configuration and a second measuring configuration,

3. The method according to any of claims 1 or 2, **characterized in that**:
- the first electromagnetic wave comprises at least one component, called first fundamental component (26), at a first frequency,
- The second electromagnetic wave comprises at least one component, called second fundamental component (27), at a second frequency distinct from the first frequency.

4. The method according to claim 3, **characterized in that** the frequencies of said first fundamental component (26) and second fundamental component (27) are in the radio frequency range.

5. The method according to any of claims 1 to 4, **characterized in that** at least one measurement signal is produced by the receiving device (28) for at least one measuring configuration in which the power of the enriched wave (23) is lower than the saturation power of said receiving device (28).

6. The method according to any of claims 1 to 5, **characterized in that** at least one measurement signal is produced by the receiving device (28) for a first measuring configuration in which the ratio of the power of a first intermodulation component to the power of a second intermodulation component is lower than the dynamics of said receiving device (28).

7. The method according to any of claims 1 to 6, **characterized in that** the step of modifying the configuration of the transmission system comprises at least one displacement step selected from:
- a step of displacing said non-linear object (20) in rotation about at least two distinct axes relative to said receiving device (28),
- a step of displacing said reflector (22) in rotation about at least two distinct axes relative to said receiving device, and
- a step of displacing said receiver (28) in translation along at least two directions distinct from each other and each being distinct from the direction of incidence of said enriched wave (23) on said receiving device.

8. The method according to any of claims 1 to 7, **characterized in that** the first source and the second source are rotatably secured to said non-linear object (20) such that the relative position of each source with respect to said non-linear object (20) is constant.

9. The method according to any of claims 1 to 8, **characterized in that** the first source and the second source are rotatably secured to said reflector (22) such that the relative position of each source with respect to said reflector (22) is constant.

10. A device for measuring power of intermodulation products produced by electromagnetic wave reflection on a non-linear object (20), comprising:
- a first electromagnetic source (24) adapted to emit from a first focus a first electromagnetic wave comprising at least one component, called first fundamental component (26),
- a second electromagnetic source (25) adapted to emit from a second focus distinct from the first focus a second electromagnetic wave comprising at least one component, called second fundamental component (27),
- a non-linear object (20) disposed so as to be able to be irradiated by said first fundamental component and second fundamental component, and to form an electromagnetic wave, called enriched wave (23), comprising said first fundamental component, said second fundamental component and components, called intermodulation components (29, 30),
- an electromagnetic receiving device (28) adapted to produce at least one signal, called measurement signal, representative of at least the power of at least one component of an electromagnetic wave received by this receiving device (28),
the measuring device being arranged in at least one spatial configuration, called measuring configuration, adapted so that said enriched wave (23) propagates at least in part up to the receiving device (28),
**characterized in that**, the enriched wave having a space-variable composition, it is adapted to be able to change the measuring configuration between a first spatial configuration, called first measuring configuration, in which the receiving device (28) receives a first portion having a first composition of the enriched wave (23), and at least one second spatial configuration, called second measuring configuration, distinct from said first measuring configuration, and in which said receiving device (28) produces at least one second measurement signal in which the receiving device (28) receives a second portion having a second composition of the enriched wave (23) distinct from the first composition of the enriched wave (23).

11. The device according to claim 10, **characterized in that** it further comprises:
- a device, called positioning device, adapted to produce digital data, called position data, representative of the measuring configuration,
- a data processing unit adapted to be able, for any measuring configuration, to receive and record in a memory position data in correlation with digital data, called measurement data, representative of at least one measurement signal produced by said receiver for a measuring configuration in which said position data have been produced.

12. The device according to any of claims 10 or 11, **characterized in that** the first source and the second source are mounted so as to be rotatably secured to said non-linear object.
